# EUROPÄISCHE PATENTSCHRIFT

(11) **EP 2 539 942 B1**
(45) Veröffentlichungstag und Bekanntmachung des Hinweises auf die Patenterteilung: **14.09.2016**
(21) Anmeldenummer: 10706524.5
(22) Anmeldetag: 22.02.2010
(51) Int. Cl.: H01L 31/032, C23C 14/06, C23C 14/22, H01L 21/02

(54) **VERFAHREN ZUR HERSTELLUNG EINER HALBLEITERSCHICHT**
PROCESS AND APPARATUS FOR FABRICATION OF A SEMICONDUCTOR LAYER
PROCÉDÉ ET DISPOSITIF POUR FABRICATION D'UNE COUCHE DE SEMICONDUCTEUR

(43) Veröffentlichungstag der Anmeldung: 02.01.2013
(73) Patentinhaber: OC3 AG, 04442 Zwenkau (DE)
(72) Erfinder: ZACHMANN, Hendrik, 04299 Leipzig (DE); OTTE, Karsten, 04277 Leipzig (DE); NEUMANN, Horst, 04509 Delitzsch (DE); SCHOLZE, Frank, 04821 Brandis (DE); PISTOL, Lutz, 04425 Taucha (DE)
(74) Vertreter: Rothe, Silke
(86) Internationale Anmeldenummer: PCT/EP2010/001093
(87) Internationale Veröffentlichungsnummer: WO 2011/100998

(56) Entgegenhaltungen:
- EP-A2- 1 422 740
- DE-A1- 19 902 908
- JP-A- 5 166 726
- JP-A- 2000 144 377
- US-A1- 2009 145 361
- US-B1- 6 498 107
- US-B2- 7 173 252
- LIPPOLD G ET AL: "Ion beam assisted deposition of Cu(In,Ga)Se2 films for thin film solar cells", MATERIALS RESEARCH SOCIETY SYMPOSIUM - PROCEEDINGS 2001 MATERIALS RESEARCH SOCIETY US, Bd. 668, 2001, Seiten H391-H396, XP002641007,

## Beschreibung

Die Erfindung betrifft ein Verfahren wie in Anspruch 1 angegeben, zur Abscheidung einer Chalkopyrit-Absorberschicht für Dünnschichtsolarzellen auf einem Schichtsystem in einem Vakuumprozess, wobei zur Herstellung eine spezielle Niederenergiebreitstrahlionenquelle zum Einsatz kommt. Die Entwicklung von hocheffizienten Solarzellen sowie deren kostengünstige Herstellung sind Hauptziele der Photovoltaik. Im Zuge dieser Entwicklung gewinnen Dünnschichtsolarzellen immer mehr an Bedeutung und werden in Zukunft größere Anteile des momentan von kristallinen Silizium-Solarzellen dominierten Marktes erschließen.

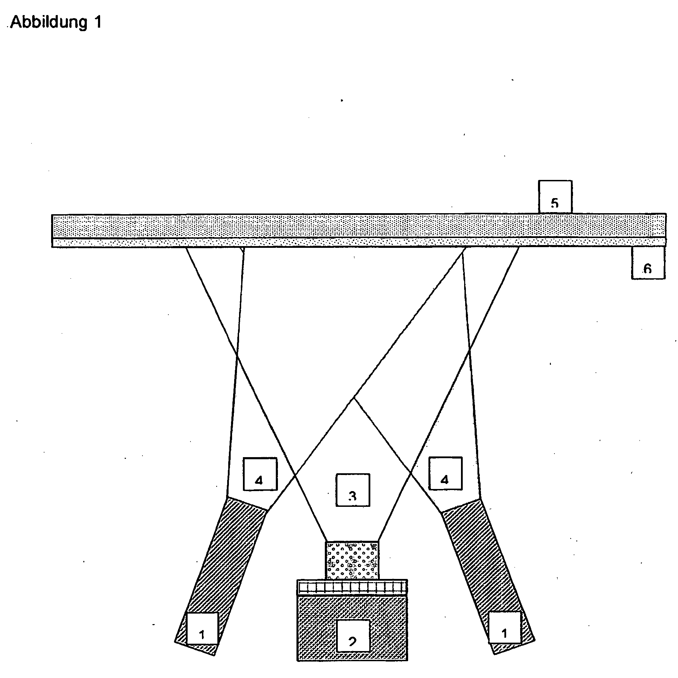

Ein erfolgversprechendes Absorbermaterial zum Einsatz in Dünnschichtsolarzellen ist das Materialsystem der Chalkopyrit-Halbleiter I-III-VI₂ mit dem derzeit am weitesten verbreiteten Vertreter CuInSe₂ und seiner Legierung Cu(In,Ga)Se₂. Ein gängiger Aufbau für Dünnschichtsolarzellen, die auf diesem Absorbermaterial basieren, besteht aus einem Glassubstrat, auf welchem ein metallischer Rückkontakt aus Molybdän aufgebracht ist; es folgt die Chalkopyrit-Absorberschicht in einer Stärke von üblicherweise 1-3 µm, darauf eine Cadmiumsulfid-Pufferschicht und abschließend ein transparenter, leitfähiger Frontkontakt, beispielsweise aus aluminiumdotiertem Zinkoxid. Derartige Solarzellen erreichen im Labor Wirkungsgrade von bis zu 19,9 %, siehe hierzu REPINS, I. et al., *Short Communication:*
*Accelerated Publication 19·9%-efficient nO*/*CdS*/*Cu(In,Ga)Se*₂ *solar cell with 81.2% fill factor,* Progress in Photovoltaics: Research and Applications 16 (2008).
Anstelle des starren Glassubstrates haben sich flexible Substrate aus Metall- oder Polymerfolien bewährt. Unabhängig von der Wahl des Substrates soll in der Folge nur von Substrat gesprochen werden. Als Beispiel für den Aufbau einer flexiblen Cu(In,Ga)Se₂-Solarzelle auf Polyimidfolie kann die Abbildung 1 auf Seite 616 in OTTE, K., MAKHOVA, L., BRAUN, A., KONOVALOV, I., Flexible Cu(In,Ga)Se2 thin-film solar cells for space application, Thin Solid Films 511-512 (2006) dienen.
Zur Abscheidung der Cu(In,Ga)Se₂-Absorberschicht sind verschiedene Verfahren bekannt. In einem sequentiellen Prozess werden beispielsweise die Metall-Komponenten Kupfer, Indium und Gallium durch vorher abgeschiedene Vorläuferschichten bereitgestellt. Anschließend wird dieser Schichtstapel durch schnelles Aufheizen in Selen-Atmosphäre chalkogenisiert, siehe hierzu HERGERT, F., JOST, S., HOCK, R., PURWINS, M.; PALM, J., Formation reactions of chalcopyrite compounds and the role of sodium doping, Thin Solid Films 515 (2007). Bei der simultanen Abscheidung durch eine Koverdampfung werden sowohl die Metall-Komponenten als auch die Chalkogen-Komponente (Selen oder Schwefel) gleichzeitig abgeschieden, siehe hierzu KESSLER, J., BODEGARD, M., HEDSTROM, J., STOLT, L., Baseline Cu(In,Ga)Se2 device production: Control and statistical significance, Solar Energy Materials and Solar Cells 67 (2001). Durch eine gezielte Anordnung der Metallverdampfer kann zusätzlich ein Element-Tiefen-Gradient in der Absorberschicht erzeugt werden, der den Wirkungsgrad der Dünnschichtsolarzelle erhöht. Bei den Abscheidungsprozessen wird in der Regel das Substrat geheizt.
Bei der simultanen oder sequentiellen Abscheidung von Cu(In,Ga)Se₂ als Absorbermaterial für Dünnschichtsolarzellen ist aus DE 199 02 908 B4 bekannt, dass die Selen-Komponente durch einen Ionenstrahl bereitgestellt werden kann, Dabei wird zum einen die Selen-Komponente in reaktiverer Form bereitgestellt, als dies bei einer reinen Selen-Verdampfung der Fall wäre. Zum anderen wird mittels der energetischen Selen-Ionen ein zusätzlicher, nichtthermischer Energiebeitrag zum Schichtwachstum bereitgestellt. Dies hat einen positiven Einfluss auf das Schichtwachstum und führt zu einer höheren Qualität des polykristallinen Absorbers bei gleichzeitig verringerter Substrattemperatur.
Von MIYAZAKI, H. et al., Growth of high-quality CuGaSe2 thin films using ionized Ga precursor, physica status solidi (a) 203 (11), 2603 (2006) ist weiterhin bekannt, dass bei der Cu(In,Ga)Se₂-Abscheidung nur Gallium in ionisierter Form angeboten werden kann. Dies hat einen positiven Einfluss auf das Schichtwachstum und die Eigenschaften der Absorberschicht. Die Gallium-Ionen entstammen dabei einer Gallium-Ionenstrahlquelle.
Weiterhin sind Feststoffionenstrahlquellen bekannt, welche für Forschungszwecke Ionen aus Materialien mit einem hohen Verdampfungspunkt (z.B. Kupfer und Indium) generieren können. Die Rate sowie die Ionenstromdichte dieser Quellen sind dabei sehr gering und damit nicht für die Schicht-Abscheidung im industriellen Maßstab geeignet.
Weiterhin ist aus DE 10 2005 040 087 A1 ein Verfahren bekannt, welches die Koverdampfung von Kupfer, Indium, Gallium und Selen beinhaltet. In der entstehenden Dampfphase werden die Elemente vermischt, wobei während des Verdampfens im Raum zwischen den Verdampferquellen und dem Substrat ein Plasma gezündet und aufrechterhalten wird. Dies führt zu einer Ionisierung und Anregung aller schichtbildenden Elemente. Bei der Herstellung von Cu(In,Ga)Se₂-Absorberschichten durch Koverdampfung werden nach dem Stand der Technik in der Regel reine Metall- und Chalkogendämpfe im Vakuum für das Einbringen von Cu, In, Ga und Se in die Absorberschicht verwendet. Diese weisen eine geringere Reaktivität bei der Cu(In,Ga)Se₂-Absorberschichtbildung auf, als angeregte und/oder ionisierte Cu-, In-, Ga- oder Se-Komponenten. Das Schichtwachstum und damit auch der Kristallitbildungsprozess werden nicht zusätzlich energetisch beeinflusst. Aus diesem Grund ist eine zusätzliche, konventionell thermische Heizung des Substrates bei der Abscheidung von Cu(In,Ga)Se₂ notwendig. In der Regel werden Temperaturen bis zu 550 °C für die Rekristallisation des Absorbers verwendet. Damit ist zum einen eine Abscheidung auf temperaturempfindlichen und damit nur niedriger heizbaren Substraten (wie zum Beispiel Polyimidfolie) nicht oder nur mit einem wesentlich geringeren Solarzellen-Wirkungsgrad möglich. Zum anderen fallen aufgrund der hohen Substrattemperaturen hohe Energiekosten bei der Herstellung der Cu(In,Ga)Se₂-Absorberschichten an.
Die gleichzeitige Anregung und/oder Ionisierung aller schichtbildenden Komponenten (Cu, In, Ga, Se) in der Beschichtungskammer mittels einer zusätzlichen Plasmaanregung kann dieses Problem nur teilweise lösen. Die Reaktivität der schichtbildenden Elemente wird zwar erhöht, ein zusätzlicher, nichtthermischer Energieeintrag in die wachsende Cu(In,Ga)Se₂-Schicht kann jedoch aufgrund der niedrigen Energie der ionisierten und/oder angeregten Teilchen von nur einigen eV nicht stattfinden. D.h. es werden weiterhin hohe Substrattemperaturen für eine ausreichend gute Kristallqualität der Absorberschicht benötigt. Ein weiterer Nachteil dieses Prozesses ist, dass durch die homogene Vermischung der Metall- und Chalkogendämpfe die Einstellung einer für die elektrischen Eigenschaften der Absorber-Schicht förderliche Tiefen-Verteilung der Elemente nicht möglich ist. Weiterhin findet keine gezielte Abscheidung auf einem Substrat, sondern zusätzlich auch der inneren Wände der Beschichtungskammer statt, was den Materialverbrauch und damit die Materialkosten bei der Herstellung von preisgünstigen Dünnschichtsolarzellen erhöht.
Von LIPPOLD, G. et.al. werden in "Materials research Society Symposium Proceedings 2001", Materials Research Society US, Bd. 668, 2001, Seiten H391 - H396 Lösungsansätze zum Abscheiden von Metall für Dünnschichtsolarzellen beschrieben, wobei ein Selenionenstrahl aus einer Breitstrahlionenquelle extrahiert wird und zum Abscheiden von Chalkopyrit (I-III-VI₂) Halbleiterschichten unter Koverdampfung von Metallkomponenten, wie Cu und In, verwendet wird.
Die nach dem Stand der Technik bekannten Feststoffionenstrahlquellen würden zwar eine Ionisierung aller Metall- und Chalkogenkomponenten ermöglichen, jedoch sind diese Ionenquellen sehr teuer, und es müsste für jede Komponente eine einzelne Ionenquelle verwendet werden. Die Verwendung dieser zusätzlichen Ionenstrahlquellen für die einzelnen Metall-Elemente hat einen sehr hohen Investitions- und Steuerungsaufwand zur Folge. Dies führt zu einem deutlichen Anstieg der Produktionskosten. Weiterhin ermöglichen diese Quellen keine Abscheidung von großflächigen Absorberschichten, da zum einen ihre Austrittsöffnung in der Regel auf einen Durchmesser <10 cm beschränkt ist und zum anderen die Feststoffionenquellen eine zu geringe Ionenstromdichte besitzen und sie damit keine für eine wirtschaftliche Produktion notwendigen Materialmengen bereitstellen können. Weiterhin liegen die mit diesen Quellen einstellbaren Ionenenergien auch deutlich über den für den Absorberabscheideprozess benötigten Ionenenergien. Die Absenkung würde zusätzlichen Kostenaufwand bedeuten.

Die Verwendung einer einzelnen Breitstrahlionenquelle für die Chalkogenkomponente erlaubt zwar eine zusätzliche nichtthermische Energiebereitstellung in der wachsenden Schicht und damit die Verwendung geringerer Substrattemperaturen; jedoch werden die Metallkomponenten (Cu, In und oder Ga) weiterhin in ihrer nicht-reaktiven Form angeboten. Dies reduziert die Wachstumsgeschwindigkeit der Absorberschicht.

Die Erfindung hat das Ziel, die Kosten zur Herstellung von Dünnschichtsolarzellen zu senken und gleichzeitig den Wirkungsgrad der Dünnschichtsolarzelle zu erhöhen. Die Aufgabe der Erfindung besteht darin, bei Verwendung einer geringen Substrattemperatur sowohl den Wirkungsrad der Solarzelle als auch die Abscheiderate zu erhöhen. Gleichzeitig sollen die Materialkosten bei der Herstellung reduziert werden.

Dies wird dadurch erreicht, dass bei der Abscheidung der Cu(In,Ga)Se₂ Absorberschicht die Chalkogenkomponente als Chalkogen-Ionenstrahl angeboten wird und gleichzeitig die Metallkomponente teilweise oder vollständig ionisiert bzw. angeregt wird. Die gleichzeitige Anregung/Ionisierung der Metallkomponente wird dadurch erreicht, dass die Verteilung des Chalkogen-Ionenstrahles in der Beschichtungskammer mit der der Metallkomponenten teilweise oder vollständig überlappt, und zusätzlich zu den Chalkogen-Ionen auch Elektronen aus einer Niederenergiebreitstrahlionenquelle extrahiert werden, deren Verteilung in der Beschichtungskammer ebenfalls mit den Metalldampfstrahlen überlappt und zu einer Ionisierung oder Anregung derselben führt. Ein wesentlicher Vorteil der Erfindung ist, dass die Anregung und/oder Ionisierung aller für die Schichtbildung benötigten Metall- und Chalkogen-Komponenten zu einer Verbesserung der strukturellen und damit elektrischen Schichteigenschaften der abgeschiedenen Absorberschicht führen. Durch die Verbesserung der elektrischen Schichteigenschaften wird eine um 10 % erhöhte Effizienz der Solarzellen erreicht. Gegenüber einem reinen Koverdampfungsprozess wird eine Wirkungsgradsteigerung von ca. 35 % erreicht. Somit kann bei gleich bleibender Absorberfläche der Ertrag der Solarzelle entscheidend gesteigert werden. Ein weiterer Vorteil ist die Verwendung nur einer einzigen Breitstrahlionenquelle in der Beschichtungskammer. Damit wird sowohl der Investitions-, Regelungs- und Steuerungsaufwand gegenüber dem Einsatz mehrer einzelner Ionenstrahlquellen deutlich verringert als auch die Beschichtungstechnologie deutlich vereinfacht. Gegenüber einer reinen Plasmabeschichtung durch die Generation eines Plasmas innerhalb der Beschichtungskammer werden die Materialkosten reduziert, da die Beschichtung gerichtet erfolgt und so weitestgehend nur die Substratoberfläche beschichtet wird. Gleichzeitig liefert der Selenionenstrahl zusätzliche nichtthermische Energie in die sich abscheidende Absorberschicht, was eine Reduzierung der thermischen Substratheizung und damit eine Reduzierung der Energiekosten ermöglicht. Die hierfür geeignete Extraktionsoptik erfordert gegenüber einem herkömmlichen Gittersystem als Vorteil geringere Anschaffungskosten sowie einen verringerten Wartungsaufwand.

Der erfindungsgemäße Verfahrensablauf wird nachfolgend anhand der Zeichnung erläutert: Ein mit einem Molybdän-Rückkontakt 6 versehenes Substrat 5 wird in die Beschichtungskammer eingelegt. Die Schichtdicke des Molybdän-Rückkontaktes 6 liegt dabei im Bereich zwischen 0,5 und 2 µm.
Nun wird in einem Vakuumprozess bei einem Druck zwischen 1·10⁻⁶ und 1·10⁻⁴ mbar auf den metallischen Rückkontakt 6 eine Cu(In,Ga)Se₂-Halbleiterschicht aufgebracht. Es werden dabei die Metall-Komponenten aus Metall-Verdampferquellen 1 in einem Raten-Verhältnis von 0,81 < Cu/(In+Ga) < 0,95 verdampft. Das für die Schichtbildung benötigte Selen wird durch einen Ionenstrahl 3 aus einer Niederenergiebreitstrahlionenquelle 2 bereitgestellt. Dabei ist die Energie der Selenionen im Bereich zwischen 10 und 500 eV wählbar.
Der Substrathalter wird bei diesem Beschichtungsschritt auf eine Temperatur zwischen 400 und 550 °C geheizt.
Durch die Ausrichtung der Metallverdampfer 1 und deren daraus resultierende Strahlführung 4 sowie durch die Ausrichtung der mit einem speziellen Extraktionssystem versehenen Ionenstrahlquelle 2 und die daraus resultierende Form und Verteilung des Selenionenstrahls und der extrahierten Elektronen 3 wird eine überlappung der Metalldampfstrahlen und des Selenionenstrahls erreicht. Das hierbei verwendete Extraktionssystem der Ionenstrahlquelle besteht aus einem Gitter mit 20 Löchern, deren Durchmesser jeweils 20 mm beträgt. An das Extraktionssystem wird relativ zur Masse und zum Substrat eine Spannung angelegt. Im Überlappungsbereich werden die Metalldampfkomponenten ionisiert und/oder angeregt und erreichen in diesem ionisierten und/oder angeregten Zustand ebenfalls das Substrat. Auf dem metallbeschichteten Substrat kommt es nun zur Abscheidung des Cu(In,Ga)Se₂-Verbindungshalbleiters in einem für die elektrischen Eigenschaften der Schicht förderlichen Element- und Energieverhältnis. Prozessgeschwindigkeit und Verdampferraten sind dabei so aufeinander abgestimmt, dass die resultierende Cu(In,Ga)Se₂-Schichtdicke zwischen 1 und 3 µm liegt.

Durch das Auftreffen der metallischen Komponenten sowie der Selen-Komponente in ionisierter und/oder angeregter Weise mit einer zusätzlichen, nichtthermischen Energie wird die Schichtbildung der Cu(In,Ga)Se₂-Absorberschicht positiv beeinflusst. Es werden bessere Schichtqualitäten erzeugt, als dies bei Verwendung reiner, nicht ionisierter/angeregter Metalldämpfe und/oder Selen-Ionen der Fall wäre. Ebenfalls ist eine höhere Abscheiderate möglich. In der folgenden Tabelle sind die Ergebnisse dieses Aüsführungsbeispiels im Vergleich zu den nach dem Stand der Technik erzielten Ergebnissen dargestellt.

| | Substrattemperatur [°C] | Solarzellen-Wirkungsgrad [%] | Wachstumsrate [nm/min] |
|---|---|---|---|
| Reiner Koverdampfungsprozess | 350-450 | 10,1 | 120 |
| Nur Selenionenstrahl | 350-450 | 12,1 | 180 |
| Erfinderisches Verfahren | 350-450 | 13,7 | 250 |

Der Grad der Ionisierung und/oder Anregung kann dabei durch geeignete Wahl der Prozessparameter an der Niederenergiebreitstrahlionenquelle eingestellt werden. Beispielhaft kann die Extraktion des Chalkogen-Ionenstrahls über ein Extraktionssystem, bestehend aus einer Blende unterschiedlicher, speziell an den Prozess angepasster Abmessungen, erfolgen. Diese Blende ermöglicht es, die Richtung und die Energie der in der Chalkogen - Niederenergiebreitstrahlionenquelle generierten Teilchen (Ionen, Elektronen und Neutralteilchen) auf dem Weg zum Substrat so einzustellen, dass die Anregung und/oder Ionisierung der Metall-Dampfkomponenten erfindungsgemäß beeinflusst wird.
Selbstverständlich ist das erfindungsgemäße Verfahren nicht auf das Materialsystem Cu(In,Ga)Se₂ beschränkt, sondern kann auf die Herstellung aller Halbleiterschichten der Gruppe I-III-VI₂ angewendet werden. Ein mögliches Elemente der Gruppe I, welches für die Abscheidung von Absorberschichten genutzt werden kann, ist dabei neben Kupfer Silber; ein mögliches Element der Gruppe III ist neben Indium und Gallium Aluminium. Die vollständige oder teilweise Ersetzung von Selen als Gruppe VI-Element durch Schwefel oder Tellur ist ebenfalls möglich.

Als Substrat können sowohl flexible Substrate (Plastik- oder Metallfolien) als auch starre Substrate (wie z.B. Glas) verwendet werden. Ebenfalls kann das Substrat bei der Beschichtung bewegt werden oder aber starr fixiert bleiben.
Das Extraktionssystem für die Niederenergiebreitstrahlionenquelle kann erfindungsgemäß auch nur eine Öffnung haben oder mehr Öffnungen mit einem Durchmesser zwischen 1 mm und 5 cm. Weiterhin kann die Öffnung auch eine andere Form (Rechteck etc.) haben.
Die Verdampfer für die metallischen Komponenten können in beliebiger Reihenfolge angeordnet werden. Ebenso ist eine beliebige Positionierung der Verdampfer in Bezug auf die Niederenergiebreitstrahlionenquelle unter Beibehaltung eines Überlappungsbereiches möglich. Die thermische Verdampfung der Metallkomponenten kann erfinderisch sowohl durch Punkt- als auch durch Linearverdampfer erfolgen.
Ebenso kann die Verdampfung der metallischen Komponenten getrennt von der Beschichtung mit der Chalkogenkomponente geschehen. Dafür wird die Niederenergiebreitstrahlionenquelle statt mit Selen mit einem inerten Hilfsgas (z. B. Argon) betrieben, sodass die Dampfstrahlen der benutzten metallischen Elemente Kupfer, Indium und Gallium die dieser Quelle entstammenden energetischen Elektronen und Ionen passieren und damit ebenfalls angeregt und/oder ionisiert werden. Die Komponenten des verwendeten Inertgases werden bei der Schichtbildung nur moderat eingebaut. Dieser moderate Einbau kann durch die Wahl des inerten Hilfsgases variiert werden.
Eine weitere Möglichkeit der Ionisierung und/oder Anregung der metallischen Komponenten, ohne für jedes Element eine eigene Ionenstrahlquelle einzusetzen, besteht darin, in die Kammer selbst eine Plasmaanregung einzubringen und damit das Plasma der Metallkomponenten selbst zu erzeugen. Diese zusätzliche Anregung kann dabei entweder anstelle oder aber zusammen mit der Chalkogen-Niederenergiebreitstrahlionenquelle betrieben werden.

### Bezugszeichenliste

- 1: Metallverdampfer
- 2: Chalkogen-Niederenergiebreitstrahlionenquelle
- 3: Chalkogen-Ionenstrahl mit extrahierten Elektronen und Neutralteilchen
- 4: Dampfstrahlen der Metallverdampfer
- 5: Substrat
- 6: Molybdän-Beschichtung auf dem Substrat als Rückkontakt

## Patentansprüche

1. Verfahren zur Herstellung einer Cu(In,Ga)(Se,S)₂-Halbleiterschicht als Absorberschicht für Dünnschichtsolarzellen durch Abscheiden von Cu, In, Ga, Se und S auf ein Substrat (5), das einen Rückkontakt (6) trägt, wobei in einer Beschichtungskammer eine Absorberschicht auf dem Substrat dergestalt aufgebaut wird, dass zunächst ein Vakuum zwischen 1 x 10⁻⁶ und 1 x 10⁻⁴ mbar erzeugt wird, das Substrat auf eine Temperatur von 200 bis 600°C erwärmt wird, in Metallverdampferquellen (1) Cu, In und/oder Ga oder deren Chalkogenidverbindungen verdampft werden und die Metalldampfstrahlen (4) auf das Substrat dergestalt fokussiert werden, dass sie auf die Substratoberfläche auftreffen, **dadurch gekennzeichnet,**
**dass** aus einer Chalkogen-Niederenergiebreitstrahlionenquelle (2) Selen und/oder Schwefel ionisiert austritt und dieser Strahl derart fokussiert auf der Oberfläche des Substrates auftrifft, dass er mit den Metalldampfstrahlen überlappt und dass
zusätzlich zu den Chalkogen-Ionen auch Elektronen (3) aus der Niederenergiebreitstrahlionenquelle (2) extrahiert werden, deren Verteilung in der Beschichtungskammer ebenfalls mit den Metalldampfstrahlen (4) überlappt und zu einer Ionisierung und/oder Anregung derselben führt,
wobei es aufgrund der durch den Chalkogenionenstrahl eingebrachten Energie zur Abscheidung der gewünschten Absorberschicht kommt.

2. Verfahren nach Anspruch 1, **dadurch gekennzeichnet, dass** eine Molybdänschicht als Rückkontakt eine Dicke von 0,5 bis 2 um aufweist, das Verhältnis der Metallkomponenten Cu zu In und/oder Ga zwischen 0,81 und 0,95 liegt, die Energie der Selenteilchen zwischen 10 und 500 eV wählbar ist, die Temperatur des Substrates während der Abscheidphase zwischen 400 und 550 Grad C liegt.

3. Verfahren nach einem oder mehreren der vorangegangenen Ansprüche, **dadurch gekennzeichnet, dass** das Cu ganz oder teilweise gegen Ag ausgetauscht wird, das Ga oder In ganz oder teilweise gegen Al, das Se ganz oder teilweise gegen S oder Te.

4. Verfahren nach einem oder mehreren der vorangegangenen Ansprüche, **dadurch gekennzeichnet, dass** unter Einsatz der Niederenergiebreitstrahlionenquelle, betrieben mit einem Inertgas, Cu, In und/oder Ga als Vorläuferschichten abgeschieden werden und erst bei Auftreffen des Chalkogen-Ionenstrahles in einem zweiten Schritt eine Cu(In,Ga)(Se,S)₂-Absorberschicht entsteht.

5. Verfahren nach einem oder mehreren der vorangegangenen Ansprüche, **dadurch gekennzeichnet, dass** das Substrat bei der Abscheidung bewegt wird.

6. Verfahren nach einem oder mehreren der vorangegangenen Ansprüche, **dadurch gekennzeichnet, dass** das Substrat flexibel ist.

7. Verfahren nach einem oder mehreren der vorangegangenen Ansprüche, **dadurch gekennzeichnet, dass** gegebenenfalls eine zusätzliche Plasmaanregung durch eine Plasmaquelle in der Beschichtungskammer zur Unterstützung der Ionisierung und/oder Anregung der Metallkomponenten installiert ist

8. Verfahren nach einem oder mehreren der vorangegangenen Ansprüche, **dadurch gekennzeichnet, dass** das Substrat oder der metallische Rückkontakt über eine Gleich- oder Wechselspannung einschließlich einer Hochfrequenzspannung vorgespannt werden.

9. Verfahren nach einem oder mehreren der vorangegangenen Ansprüche, **dadurch gekennzeichnet, dass** Wasserstoff, Stickstoff, Argon oder Helium zur Unterstützung des beschriebenen Abscheideprozesses zur Anwendung kommen

10. Verfahren nach einem oder mehreren der vorangegangenen Ansprüche, **dadurch gekennzeichnet, dass** die Metall-Komponenten vor dem Auftreffen auf das Schichtsystem bereits als binäre Verbindung (z.B. Cu₂Se oder In₂Se₃) vorliegen.

## Claims

1. A method for producing a Cu(In,Ga)(Se,S)₂ semiconductor layer as an absorber film for thin-film solar cells by depositing Cu, In, Ga, Se, and S onto a substrate that carries a back contact, wherein an absorber film is built up on the substrate in a deposition chamber such that, first, a vacuum is generated in the range between 1 x 10⁻⁶ and 1 x 10⁻⁴ mbar, the substrate is heated to a temperature of 200 to 600°C, Cu, In, and/or Ga or their chalcogenide compounds are vaporized in metal vapor sources and the metal vapor beams are focused onto the surface such that they hit the substrate surface, **characterized in that**,
selenium and/or sulfur exit in ionized form from a chalcogen low-energy broad-beam ion source and this beam hits the surface of the substrate in such a focused manner that it overlaps with the metal vapor beams, and that
in addition to said chalcogen ions, electrons from the low-energy broad-beam ion source are extracted whose distribution in the deposition chamber also overlaps with the metal vapor beams and results in ionization and/or excitation of the same,
wherein the energy introduced by the chalcogen beam results in the deposition of the desired absorber film.

2. The method according to claim 1, **characterized in that** a molybdenum layer as back contact has a thickness between 0.5 and 2 µm, the ratio of the Cu to In and/or Ga metal components is between 0.81 and 0.95, the energy of the selenium particles can be selected between 10 and 500 eV, the temperature of the substrate is between 400 and 550 degrees Celsius during the deposition phase.

3. The method according to one or several of the preceding claims, **characterized in that** the Cu is completely or partially replaced with Ag, the Ga or in is completely or partially replaced with Al, and the Se is completely or partially replaced with S or Te.

4. The method according to one or several of the preceding claims, **characterized in that** Cu, In and/or Ga are deposited as precursor films using the low energy broad beam ion source that is operated with an inert gas, and a Cu(In,Ga)(Se,S)₂ absorber film develops only when the chalcogen ion beam hits in a second step.

5. The method according to one or several of the preceding claims, **characterized in that** the substrate is moved during the deposition.

6. The method according to one or several of the preceding claims, **characterized in that** the substrate is flexible.

7. The method according to one or several of the preceding claims, **characterized in that** an additional plasma excitation by a plasma source may optionally be installed in the deposition chamber to support the ionization and/or excitation of the metal components.

8. The method according to one or several of the preceding claims, **characterized in that** the substrate or the metallic back contact are biased by a direct or alternating voltage including a high frequency voltage.

9. The method according to one or several of the preceding claims, **characterized in that** hydrogen, nitrogen, argon, or helium are used for supporting the deposition process described.

10. The method according to one or several of the preceding claims, **characterized in that** the metal components are already present as a binary compound (e.g. Cu₂Se or In₂Se₃) before they hit the film system.

## Revendications

1. Procédé de formation d'une surface semi-conductrice de Cu(In, Ga)(Se, S)₂ en tant que couche absorbante pour piles solaires en couche mince, ce qui est obtenu par la séparation de Cu, In, Ga, Se et S sur un substrat qui, lui, porte un contact de retour, où une couche absorbante disposée sur le substrat est structurée dans une chambre de revêtement de telle sorte que d'abord se produise un vide entre 1 x 10⁻⁶ et 1 x 10⁻⁴ mbar, où le substrat est chauffé jusqu'à une température de 200 à 600°C, où les éléments chimiques Cu, In et/ou Ga ou leurs substances sont vaporisés dans des sources d'évaporation de métaux, et où les jets de vapeur métallique sont focalisés sur le substrat de telle manière que la surface du propre substrat constitue leur point d'impact, **caractérisé par le fait**
**qu'**une source d'ions de chalcogénures à large faisceau et de basse énergie produit une dispersion de sélénium et/ou de soufre ionisé, que ce jet est focalisé lors de son impact sur la surface du substrat de telle sorte qu'il se chevauche avec les jets de vapeur métallique et que, en plus des ions de chalcogénures, des électrons sont extraits de la source d'ions de chalcogénures à large faisceau et de basse énergie, dont la distribution dans la chambre de revêtement se chevauche également avec les jets de vapeur métallique, ce qui aboutit à une ionisation et/ou à une excitation des ces derniers et, grâce à l'énergie produite par le faisceau de chalcogénures, à la séparation de la couche absorbante demandée.

2. Procédé selon la revendication 1, **caractérisé par le fait qu'**une couche de molybdène agissant en tant que contact de retour présente une épaisseur de 0,5 à 2 µm, que le rapport entre les composés métalliques de Cu et les éléments chimiques In et/ou Ga est de 0,81 à 0,95, que l'énergie des particules de sélénium peut être choisie de 10 à 500 électronvolt et que, lors de la phase de séparation, la température du substrat varie entre 400 et 550 °C.

3. Procédé selon l'une quelconque des revendications précédentes, **caractérisé par le fait que** Cu est remplacé en totalité ou en partie par Ag, que Ga ou In est remplacé en totalité ou en partie par Al et que Se est remplacé en totalité ou en partie par S ou Te.

4. Procédé selon l'une quelconque des revendications précédentes, **caractérisé par le fait qu'**on utilisant la source d'ions de chalcogénures à large faisceau et de basse énergie qui, elle, fonctionne à l'aide d'un gaz inerte, les éléments chimiques Cu, In et/ou Ga sont séparés sous forme de couches préalables et qu'une couche absorbante de Cu(In, Ga)(Se, S)₂ n'est formée que durant une deuxième phase, à savoir lors de l'impact du faisceau ionique de chalcogénures.

5. Procédé selon l'une quelconque des revendications précédentes, **caractérisé par le fait que** le substrat est déplacé lors du processus de séparation.

6. Procédé selon l'une quelconque des revendications précédentes, **caractérisé par le fait que** le substrat est flexible.

7. Procédé selon l'une quelconque des revendications précédentes, **caractérisé par le fait que**, le cas échéant, une excitation complémentaire du plasma qui, elle, est produite par une source de plasma, est installée dans la chambre de revêtement, ceci pour soutenir l'ionisation et/ou l'excitation des composés métalliques.

8. Procédé selon l'une quelconque des revendications précédentes, **caractérisé par le fait que** le substrat ou le contact de retour métallique sont mis en tension de polarisation par l'intermédiaire d'une tension continue ou alternée, y compris par une tension à haute fréquence.

9. Procédé selon l'une quelconque des revendications précédentes, **caractérisé par le fait que** des éléments chimiques ou des gaz comme hydrogène, azote, argon ou hélium sont utilisés pour soutenir le processus de séparation ci-dessus.

10. Procédé selon l'une quelconque des revendications précédentes, **caractérisé par le fait que** les composés métalliques sont déjà existants en tant que combinaisons binaires (par exemple Cu₂Se ou In₂Se₃) avant leur impact sur le système de couches.
